# EUROPEAN PATENT APPLICATION

(11) **EP 2 431 995 A1**
(43) Date of publication of application: **21.03.2012**
(21) Application number: 10177403.2
(22) Date of filing: 17.09.2010
(51) Int. Cl.: H01J 37/32

(54) **IONISATION DEVICE**

(71) Applicant: Asociacion de la Industria Navarra (AIN), 31191 Cordovilla (Navarra ) (ES); Gencoa Limited, Liverpool L24 9HP (GB)
(72) Inventor: Bellido-González, Victor, Liverpool, L24 9HP (GB); García Fuentes, Gonzalo, 31191 Cordovilla (Navarra) (ES); García Lorente, José Antonio, 31191 Cordovilla (Navarra) (ES); Rodrígez Trías, Rafael, 31191 Cordovilla (Navarra) (ES)
(74) Representative: Cabinet Plasseraud

(57) **Abstract**

Ionisation device, comprising a linear hollow cathode device (1) which has hollow cathode electrodes (3a and 3b), defining a main hollow cathode electrode gap (10) in which a magnetic field created by means of magnetic elements (4a-4b) is confined; and a gas distribution element (2) in which a gas distribution cavity (2a) is arranged providing uniform gas distribution on the main hollow cathode electrode gap (10) with suitable powering which in a substantially vacuum environment would be able to produce a substantially linear plasma discharge (6) which is spatially extended by the relative position of the hollow cathode electrodes (3a and 3b) and an anode element (5) wherein this extended plasma (6) allowing a wide interaction with particles travelling from a coating material source (7) ionised in order to produce a coating or a plasma treatment on a substrate (11) surface.

## Description

### Field of the art

This invention relates to the ionisation discharge in vacuum coating technology applied to the ionisation enhancement of mainly non ionised particles in a low pressure rarerified environment. Particles could be noble gases, other gases (such as N2, 02), vapours (from liquids or solid sources) and nebulized media. This invention also relates to the use of such devices and control during non-reactive and reactive processes, with or without feedback plasma process control.

### State of the art

Coating quality in vacuum coating technology depends on many factors. One of those factors is the degree of ionisation of particles on the vapour phase. In many instances a higher degree of ionisation brings some enhancement on coating properties. In manufacturing processes the deposition rate is one of the most important factors which would make a process commercially viable. Another very important coating property is the defect density as the number of defects on a coating would determine the limitation of its practical use. Typically the vacuum coating processes with high degree of ionisation do not provide high deposition rates, and when they do the number of defects tends to be very high. A way to bring a solution to the problem is the separation between the vapour source, also called coating source, and the ionisation source as in the following inventions where they use a series of hollow cathode guns. [FRAUNHOFER GES FORSCHUNG [DE], DE19943379 (A1)]; [FRAUNHOFER GES FORSCHUNG [DE], US7541070 (B2)]; [FRAUNHOFER GES FORSCHUNG [DE]; FAHLTEICH JOHN [DE]; FAHLAND MATTHIAS [DE]; SCHOENBERGER WALDEMAR [DE]; SCHILLER NICOLAS [DE], DE10200801966 (A1), W02009127373 (A1)].

The above inventions rely on several discrete ionisation sources in order to provide ionisation treatment over a large area substrate. The very nature of the discrete ionisation sources represents a problem when the coating source is in nature continuous and on those cases peaks and trough of coating properties can be expected across the substrate area. This is the result of coating flux and ion flux not being uniform.

The present invention improves the operation and performance of ionisation process by providing continuous ionising plasma across the substrate area. The present invention also incorporates elements to adapt to gradual differences in coating flux by influencing a gradual change in the continuous ion flux. The present invention is specially suited for when the coating flux is provided in a substantially continuous way across the substrate area.

### Object of the invention

According to the present invention a substantially continuous ionisation plasma source capable of supplying a wide area uniform ionisation is provided. The invention could also produce gradual changes in ionisation uniformity in order to adapt to coating flux uniformity requirements or surface treatment requirements.

The invention also relates to the use of this source for the ionisation enhancement of particles which could be noble gases, other gases (such as N₂, O₂), vapours (from liquids or solid sources) and nebulized media. is able to operate in reactive and non reactive environments.

The present invention is based on a linear hollow cathode device. The magnetic field is provided by magnetic elements which could be substantially permanent magnets or electromagnets to which magnetic field has been linearised in order to provide a equivalent hollow electron trap along the source. The present invention incorporates adjustable hollow cathode electrodes which optimise the hollow cathode gap and trap length based on the size of the source and the operating pressure, gas flow injection and gas nature. The present invention requires a gas injection device that controls the gas distribution along the linear length of the source. The present invention also requires a remote anode element which is at a substantially positive potential with respect to the surrounding area and allows the extension of the linear hollow cathode plasma over a substantial length. It is intended in the present invention that the required particles to be ionised would be able to cross the linear plasma between the linear hollow cathode device and the anode element. Typically for reactive depositions the anode element would have an structure preventing it from becoming covered from non conductive material, such as oxides. Typically in those cases a gas injection device would also be required on the structural parts of the anode element.

In addition the plasma interaction with substrate could be controlled in order to control specific coating deposition requirements, e.g. ion bombardment per deposited atom.

Another embodiment of the present invention relates to the use of two linear hollow cathode devices operated in AC mode where the units alternate their function as anode and cathode.

The present invention also relates to the use of these devices in both reactive and non-reactive environments, for example, deposition of AlOx from Al evaporation sources or Al sputtering targets. Another example would be the use of the source for plasmapolymeratisation where a monomer or a catalyst could be ionised in order to create a polymerisation reaction.

The present invention also relates to use of a feedback control system which could incorporate different sensors such as optical sensors looking athe the plasma emissions, impedance sensors looking for example at the operative voltage, or partial gas sensors which for example could look at the partial pressure of a gas, typically reactive gas which in turn is related to the degree of reaction and or consumption in the process. The feedback control system would produce suitable actuations such as gas flow injections or power supply power, current or voltage.

The present invention also relates to substrates that may or may not be biased.

The present invention relates to any magnetron sputtering application such as web, glass, display, decorative and batch coaters.

The invention will be further described by way of example only with reference to the following figures in which:

### Description of the figures

Figure 1 shows a cross section of the current state of the art showing a discrete cylindrical hollow cathode guns producing a plasma plume.
Figure 2 shows another cross section of the current state of the art showing different discrete cylindrical hollow cathodes which produce corresponding plasma plumes.
Figure 3 shows a cross section of the present invention where a linear hollow cathode device produces substantially continuous plasma.
Figure 4 shows another cross section of the present invention.
Figure 5 shows another cross section of the present invention.
Figure 6 shows a cross section of another arrangement of the present invention where the anode element of figures 4 and 5 is replaced by another linear hollow cathode device.
Figure 7 shows a cross section of a typical, but not exclusively, gas distribution element.
Figure 8 shows a cross section of a typical magnetic field line arrangement produced by the magnetic elements.
Figure 9 shows a front view of an example of linear hollow cathode device.
Figure 10 shows a cross section of a possible embodiment of anode element.
Figure 11 shows an schematic of additional elements for the operation of the present invention.

### Detailed description of the invention

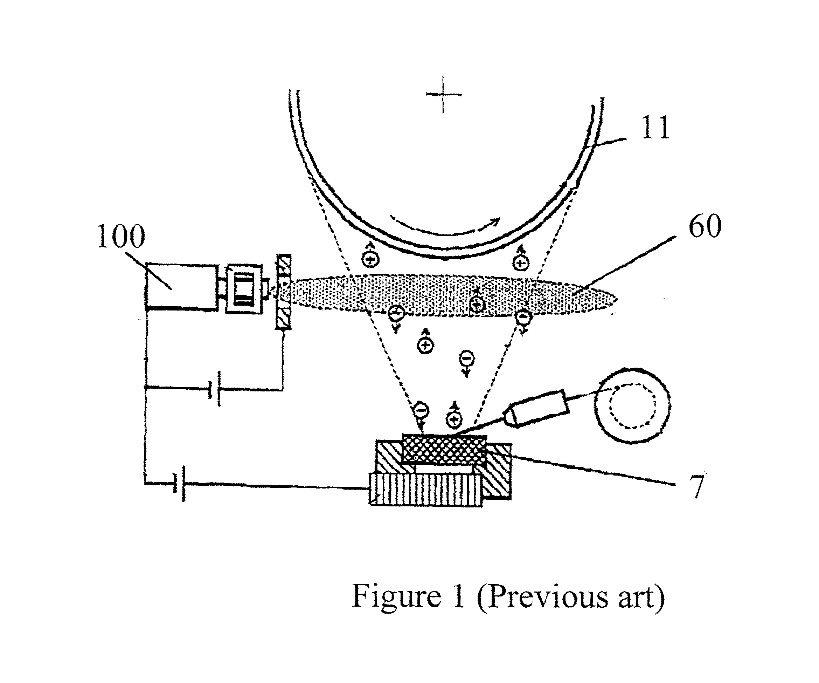

Figure 1 shows a cross section of the current state of the art. Discrete cylindrical hollow cathode guns (100) produce a plasma plume (60). The coating materials source (7) produce particles which would ionisied as they cross the area of plasma (60) and a coating would be produced on substrate (11).

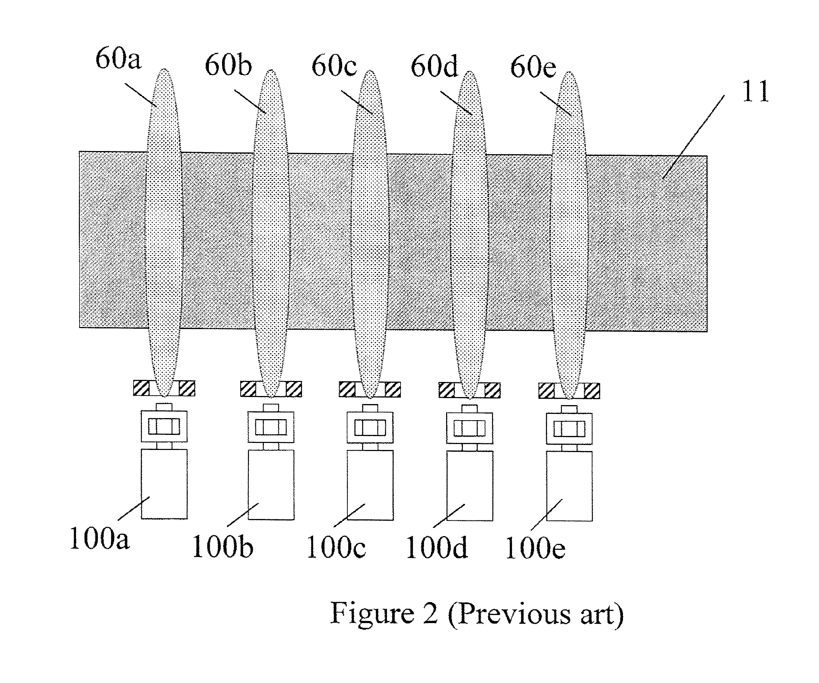

Figure 2 shows another cross section of the current state of the art showing different discrete cylindrical hollow cathodes (100a-100e). These sources would produce corresponding plasma plumes (60a-e). The substrate (11) would in this case be exposed to a series of high ionisation areas and low ionisation areas where the plasma is not present.

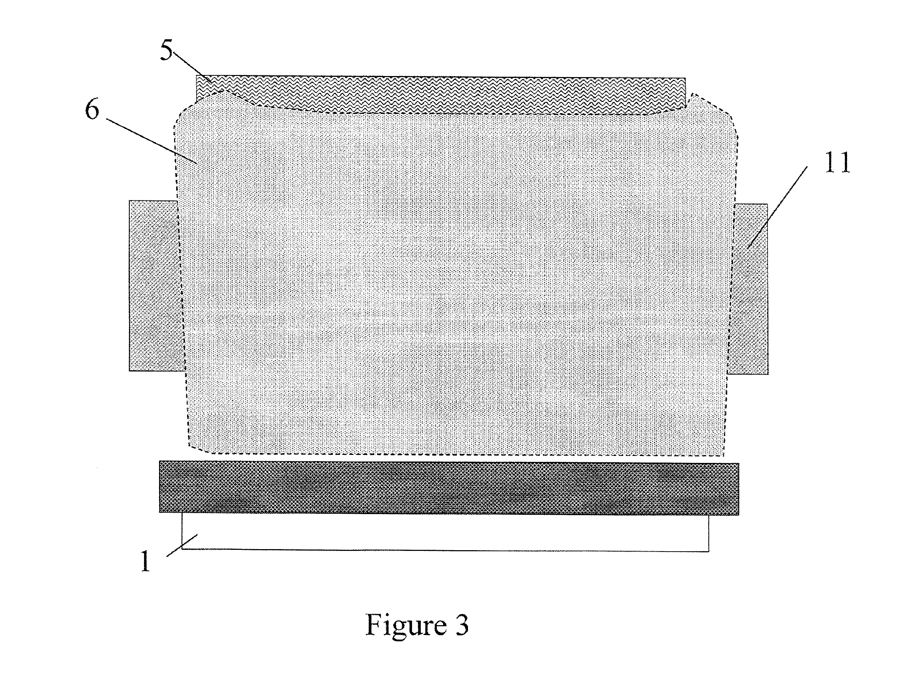

Figure 3 shows a cross section of the present invention where the linear hollow cathode device (1) produces substantially continuous plasma (6) which extends towards an operative anode element (5) and in that way provided an uniform plasma exposure of substrate (11) along the linear hollow cathode length. Typically the operative anode element (5) would be biased at positive voltages above +1 Volt. Typically between +20 and +400 Volts.

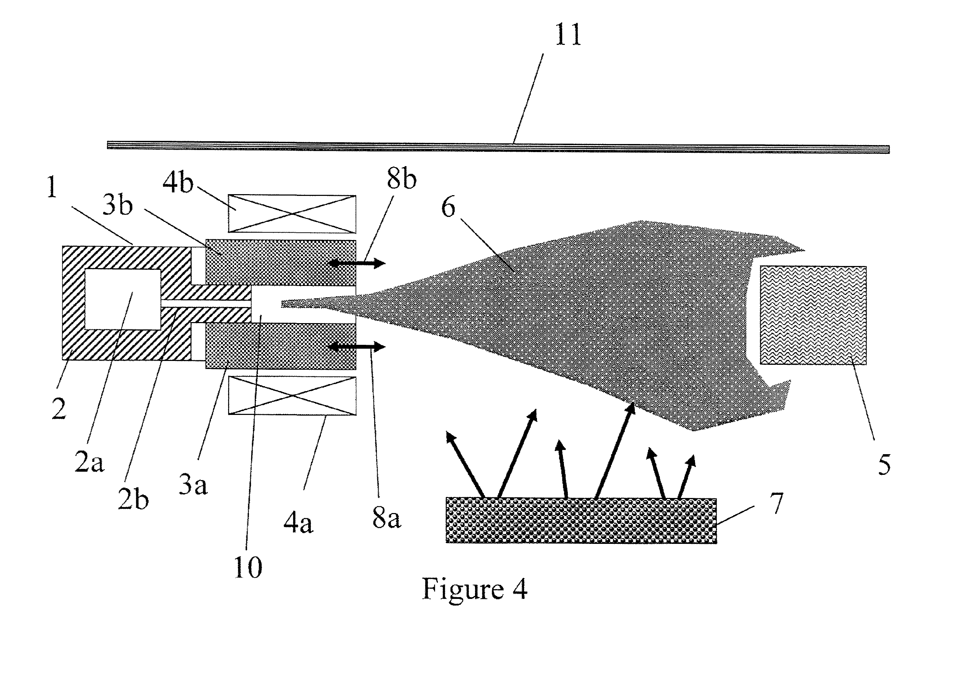

Figure 4 shows another cross section of the present invention. The linear hollow cathode device (1) contains a gas distribution element (2) in which a gas distribution cavity (2a), or a plurality of them, distributes a gas along the linear length of the element (2). Typically a plurality of holes (2b) would release an even gas distribution on to the main hollow cathode electrode gap (10) which is defined by the positions of the gas distribution element (2) and the hollow cathode electrodes (3a and 3b). The hollow cathode effect is enhanced by adequate magnetic field confinement which is created by magnetic elements (4a-4b). Adjustments (8a-8b) on the hollow cathode electrodes (3a and 3b) allowing horizontal displacement of the electrodes together with adjustments on the magnetic field confinement allow suitable tunability of the linear hollow cathode device (1) for the ignition and the sustaining of a stable plasma (6) which extends to wards the anode element (5). Anode element (5) in its totality or in part contains elements that are positively biased with respect to the potential of the linear hollow cathode device (1) and the surrounding electric potentials. Typically any particle generator device would produce a flux of material (7) which could be released by different phenomena (for example, and not exclusively: thermal evaporation, sublimation, nebulisation, sputtering, cathodic arc, reactive gas, monomer vapour injection). The particles as they cross the plasma zone 6 would undergo ionisation or plasma excitation (generally in part only but it could be also in its totality). The particles would then arrive to substrate (11) in order to produce a surface treatment which could be for example etching, coating deposition, polymerasiation, functionalization, surface cleaning, outgassing, etc. The arriving particles would be on average at higher level of energy than the original flux of material (7).

The magnetic field could be adjusted by means of location of magnetic elements or by electromagnetic adjustments on magnetic elements (4a-b) where the magnetic elements could comprise any plurality of permanent magnets, ferromagnetic materials and electromagnetic coils.

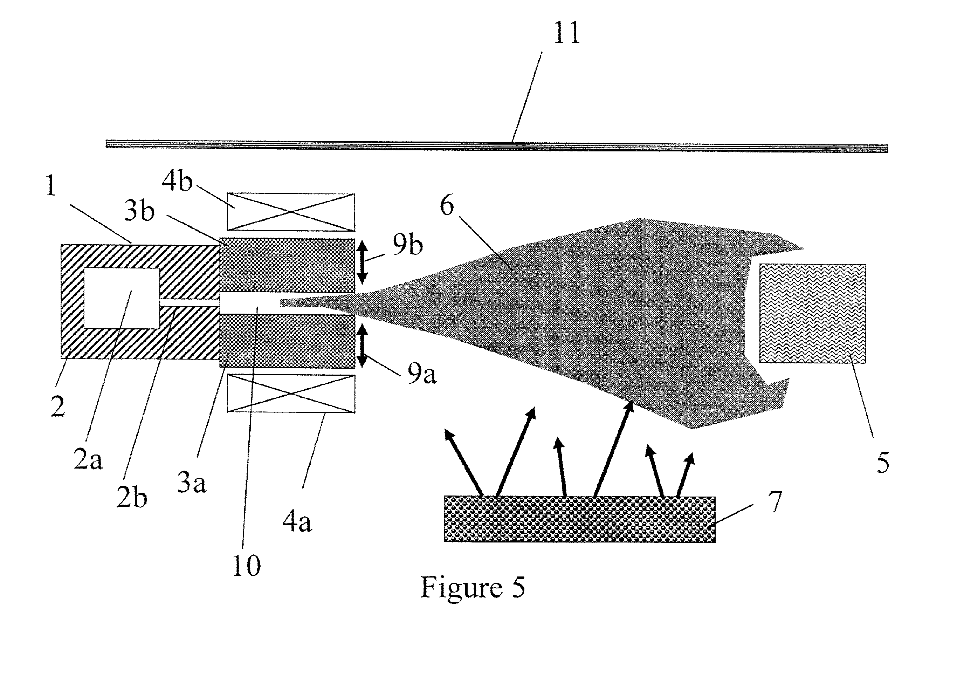

Figure 5 shows another cross section of the present invention. The linear hollow cathode device (1) contains a gas distribution element (2) in which a gas distribution cavity (2a), or a plurality of them, distributes a gas along the linear length of the element (2). Typically a plurality of holes (2b) would release an even gas distribution on to the main hollow cathode electrode gap (10) which is defined by the positions of the gas distribution element (2) and the hollow cathode electrodes (3a and 3b). The hollow cathode effect is enhanced by adequate magnetic field confinement which is created by magnetic elements (4a-4b). Adjustments (9a-9b) on the hollow cathode electrodes (3a and 3b) allowing vertical displacement of the electrodes together with adjustments on the magnetic field confinement allow suitable tunability of the linear hollow cathode device (1) for the ignition and the sustaining of stable plasma (6) which extends to wards the anode element (5). Anode element (5) in its totality or in part contains elements that are positively biased with respect to the potential of the linear hollow cathode device (1) and the surrounding electric potentials. Typically any particle generator device would produce a flux of material (7) which could be released by different phenomena (for example, and not exclusively: thermal evaporation, sublimation, nebulisation, sputtering, cathodic arc, reactive gas, monomer vapour injection). The particles as they cross the plasma zone (6) would undergo ionisation or plasma excitation (generally in part only but it could be also in its totality). The particles would then arrive to substrate (11) in order to produce a surface treatment which could be for example etching, coating deposition, polymerasiation, functionalization, surface cleaning, outgassing, etc. The arriving particles would be on average at higher level of energy than the original flux of material (7) . Material (7) could undergo transformation by the nature of the plasma exposure, for example from monomer to polymer, or by the plasma gas chemistry, for example from Alumnium to alumnium oxide if the gas injected in the plasma contains a suitable amount on oxygen.

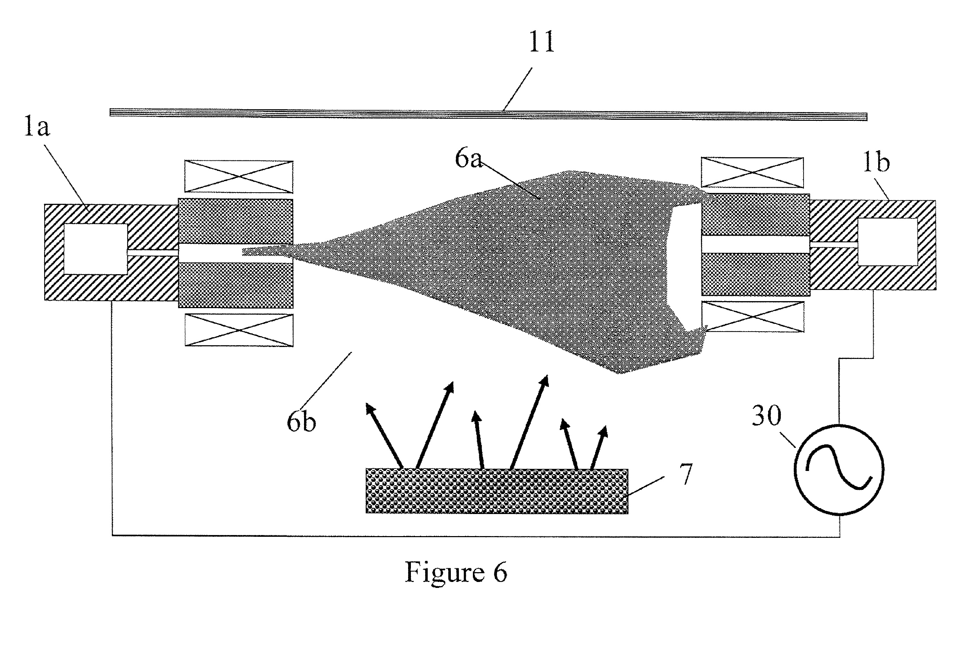

Figure 6 shows a cross section of another arrangement of the present invention where the anode element (5) of figures 4 and 5 is replaced by another linear hollow cathode device (1b). Hence the typical arrangement of this example has two linear hollow cathode devices (1a-1b) which could be arranged in front of each other, such as in this Figure 6 is represented, or at a certain angle different from 180 degrees. Typically, but not exclusively, this arrangement would work using AC medium frequency (in the 1-1000 kHz range) by means of a suitable power supply (30). When operating in AC mode the hollow linear cathode devices (1a and 1b) alternate their functionality as cathode and anode which in turn corresponds to alternative plasmas (6a-6b) being formed usually at a very high frequency, therefore not affecting the process uniformity on substrate (11). Material (7) flux would be affected by ionisation and excitation processes in the combined plasma (6a-6b).

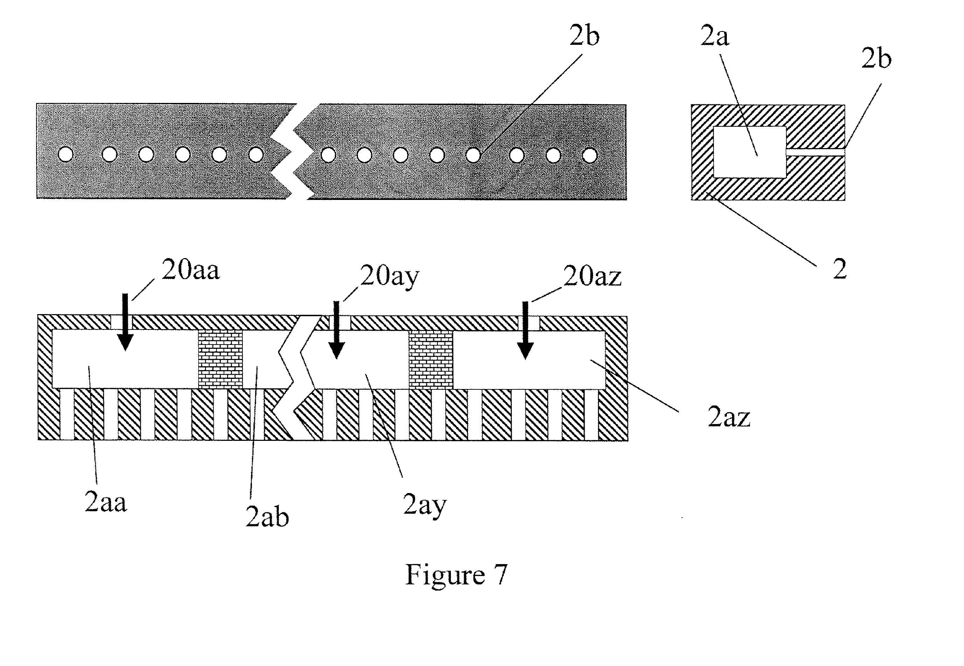

Figure 7 shows a cross section of a typical, but not exclusively, gas distribution element (2) in which a gas distribution cavity (2a), or a plurality of them, distributes a gas along the linear length of the element (2). Typically a plurality of holes (2b) would release an even gas distribution on to the main hollow cathode electrode gap. For uniformity tayloring purposes a typical gas distribution element would comprised of a number of individual gas distribution cavities (2aa, 2ab, ...2ay,2az). the numbers of cavity could be any entire number(1,2,3,4,...) however a preferred option would be a non even number (1,3,5,7,9,...). The number of cavities (2aa, 2ab, ...2ay,2az) would depend on the length of the linear hollow cathode device (1) and the degree of uniformity control that is needed to be achieved. On each of the corresponding cavities a gas injection (or a plurality of them) is provided. Gas injections (20aa, ...20ay,20az) could be made of a single gas or a mixture of gases and vapours.

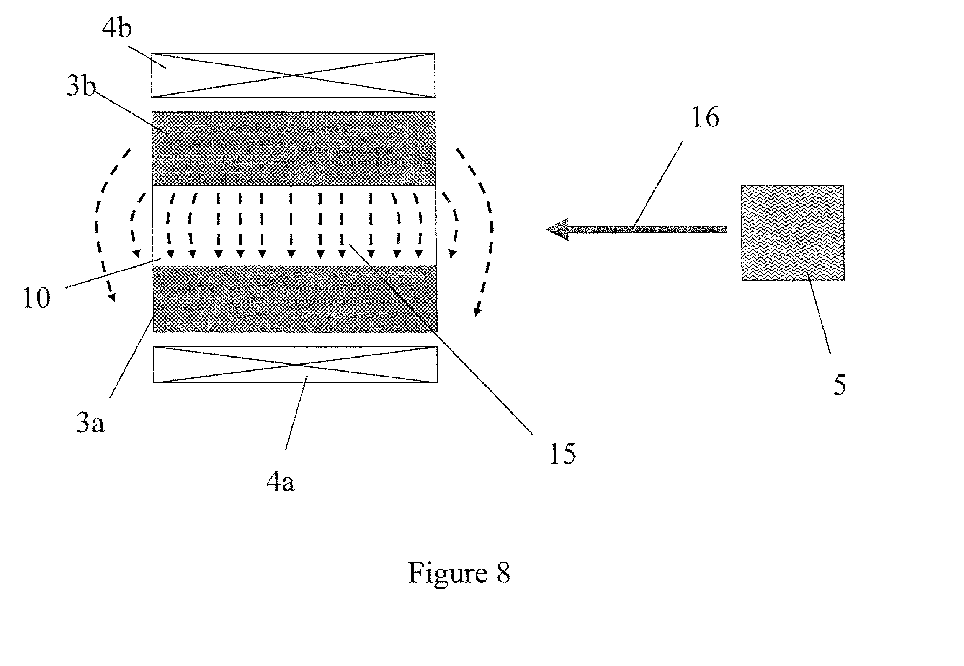

Figure 8 shows a cross section of a typical magnetic field line arrangement (15) produced by the magnetic elements (4a-4b) in the main hollow cathode electrode gap (10) which is defined by the hollow cathode electrodes (3a-3b). The anode element (5) would produce a directional electric field (16) responsible for the extension of the plasma (6) (electron path) across the distance between the linear hollow cathode device (1) and the anode element (5).

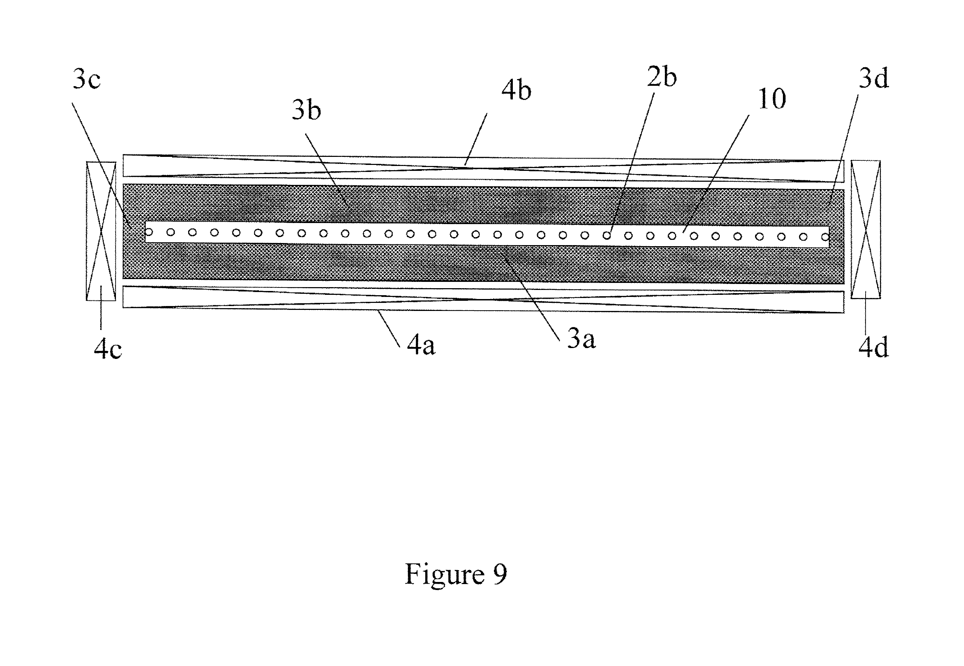

Figure 9 shows a front view of an example of linear hollow cathode device (1) with magnetic elements (4a, 4b, 4c, 4d) responsible for the creation of the suitable magnetic field. Electrodes (3a,3b,3c,3d) are responsible for the cathodic component of the hollow cathode operation. The gas injection through a series of holes (2b) along the length of the device (1) would allow the hollow cathode discharge to be generated in gap (10) once all the necessary plasma discharge conditions are met.

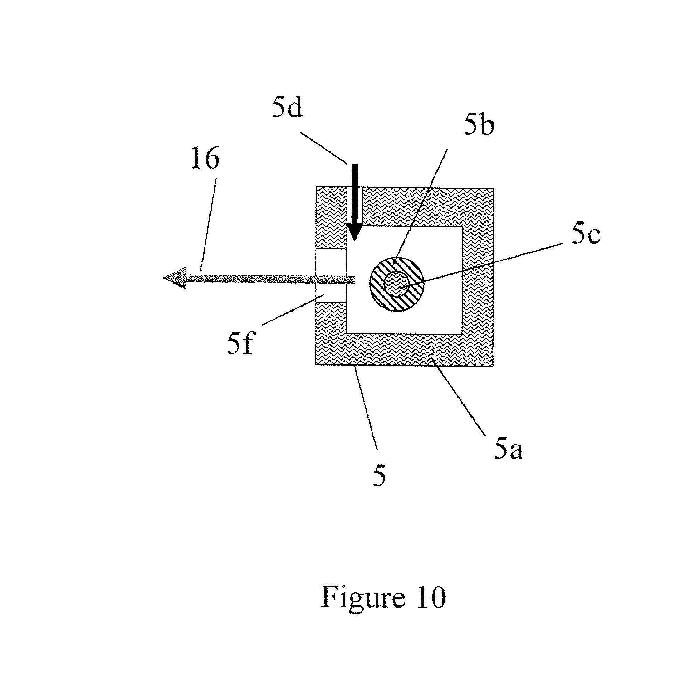

Figure 10 shows a cross section of a possible embodiment of anode element (5). Typically, especially when the anode element (5) operability depends on a stable clean anode condition, the anode element (5) would have a shield (5a), protecting the inner anode (5b) from particle contamination. Inner anode (5b) would typically have means of suitable cooling (5c). In many instances a gas injection (5d) is desirable in order to increase the cleanliness of the inner anode (5b). Some gas injection would also allow extra protection by active cleaning of the cooling means (5c). This generally occurs when the injected gases (5d) are able to generate negative ions which would be attracted to the positively charged inner anode (5b) and the anode element (5) is biased at a suitable high positive potential (typically more than +200 Volts). An example of these gases is oxygen. The inner anode (5b) would be responsible for the electric field (16) which would guide the electrons generated at the linear hollow cathode device (1).

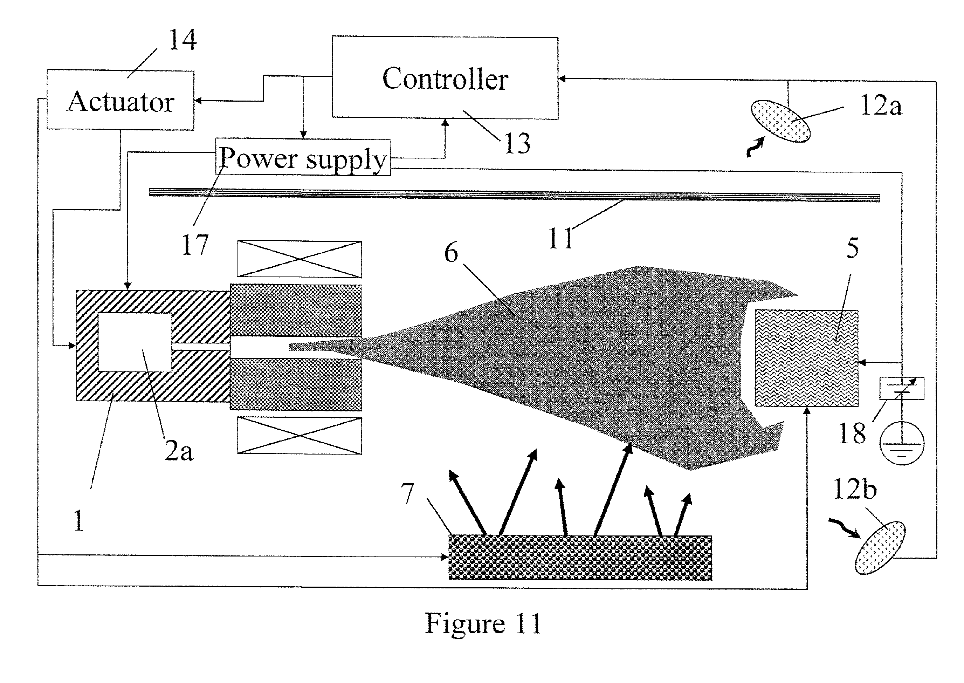

Figure 11 shows a schematic of additional elements for the operation of the present invention. Typically a power supply (17) would connect both the linear hollow cathode device (1) and the anode element (5). Anode element (5) has a potential typically positive with respect to ground and the potential could be varied by suitable means (18). The plasma (6) would extend from the area of electron generation (linear hollow cathode device (1) to the anode element (5). It would be possible to install suitable feedback control on the operation of the linear hollow cathode device (1) by means of suitable sensors for example (12a-12b) which could be of optical nature (for example looking at the plasma generated which would excite gas particles and also material particles from the material source 7). Sensor elements could be in some cases located behind the substrate (11), as the sensor (12a) in this example, for example in the case of a transparent plastic web, or glass allowing to look through the transparency of the material in that way also keeping the sensor elements clean from deposited material. sensors could also be sensing a suitable partial pressure, for example oxygen sensor, or could be based on impedance signals such as the plasma discharge voltage, typically signals generated at the power supply (17). All those suitable signals are fed into the feedback controller (13) and suitable actuations are commanded and executed via actuators (14), for example gas flow changes on injection to gas distribution cavities (2a). Some actuations could also be implemented on the material source (7) (for example releasing more or less material into the vapour flow) and on the power supply (17), as an example.

## Claims

1. Ionisation device providing a plasma (6) through which particles from a coating material source (7) are ionized to produce a coating in a substrate (11), **characterized in that** the ionisation device comprises a linear hollow cathode device (1) which has hollow cathode electrodes (3a and 3b), defining a main hollow cathode electrode gap (10) in which a magnetic field created by means of magnetic elements (4a-4b) is confined; and a gas distribution element (2) in which a gas distribution cavity (2a) is arranged providing uniform gas distribution on the main hollow cathode electrode gap (10) with suitable powering which in a substantially vacuum environment would be able to produce a substantially linear plasma discharge (6) which is spatially extended by the relative position of the hollow cathode electrodes (3a and 3b) and an anode element (5) wherein this extended plasma (6) allowing a wide interaction with particles travelling from the coating material source (7) ionised in order to produce a coating or a plasma treatment on the substrate (11) surface.

2. Ionisation device according to claim 1, **characterized in that** instead of the anode element (5), there is arranged a linear hollow cathode device (1b) facing a linear hollow cathode device (1a) and between the linear hollow cathodes (1a and 1b) a power supply (30) is arranged, in such a way that the devices (1a and 1b) alternate in function as anode and cathode.

3. Ionisation device according to claim 1, **characterized in that** the main gas distribution cavity (2a) is divided in any number of individual gas distribution cavities (2aa, 2ab,...) which by independent control of the gas flow allocated to each cavity could provided a desired gas injection (20aa,...,20ay) profile along the length as it is injected into the gap electrode gap 10.

4. Ionisation device according to claim 4, **characterized in that** the gas injected could comprise of a single gas or a mixture of gases and or vapours.

5. Ionisation device according to claim 1, **characterized in that** the hollow cathode electrodes (3a and 3b) are adjustable by means of vertical displacement and by means of horizontal displacement.

6. Ionisation device according to claim 1, **characterized in that** the magnetic field could be adjusted by means of location of magnetic elements or by electromagnetic adjustments on magnetic elements (4a-b) where the magnetic elements could comprise any plurality of permanent magnets, ferromagnetic materials and electromagnetic coils.

7. Ionisation device according to claim 1, **characterized in that** the anode element (5) is formed by a shield (5a) protecting an inner anode (5b) provided with cooling means (5c), and by a gas injection (5d) for long term process stability as the inner anode (5b) could remain clean from contaminants during the process.

8. Ionisation device according to claim 1, **characterized in that** the anode element (5) has means (18) for varying its potential.

9. Ionisation device according to claim 1, **characterized in that** the linear hollow cathode device (1) has a feedback control where sensors (12a and 12b) send signals of the process to a controller (13), which after process command changes on actuators (14) which produce changes in the gas injection flows in the cavities (2a) or changes in the coating material source (7).

10. A method of processing, depositing or plasma treating a component or substrate utilizing the ionisation device according to any of the aforementioned claims.
